# EUROPEAN PATENT APPLICATION

(11) **EP 3 439 170 A1**
(43) Date of publication of application: **06.02.2019**
(21) Application number: 18187209.4
(22) Date of filing: 03.08.2018
(51) Int. Cl.: H02S 20/23

(54) **GROOVE TYPE MOUNTING BRACKET, PHOTOVOLTAIC POWER GENERATION UNIT AND METHOD FOR MOUNTING PHOTOVOLTAIC POWER GENERATION ASSEMBLY**

(30) Priority: 04.08.2017 CN 201720969747 U; 04.08.2017 CN 201710662356; 04.08.2017 CN 201720970216 U
(71) Applicant: Beijing Apollo Ding Rong Solar Technology Co., Ltd., Beijing 100176 (CN)
(72) Inventor: DAI, Fengyu, Beijing, Beijing 100176 (CN); WANG, Yunfang, Beijing, Beijing 100176 (CN); HUO, Yanyin, Beijing, Beijing 100176 (CN); CAO, Zhifeng, Beijing, Beijing 100176 (CN)
(74) Representative: D'Halleweyn, Nele Veerle Trees Gertrudis

(57) **Abstract**

A groove type mounting bracket, a photovoltaic power generation unit and a method for mounting a photovoltaic power generation assembly are provided. The groove type mounting bracket includes a support plate and grooves arranged on the sides of the support plate. The groove is suitable for snap-fitting with a vertical member which extends on a building surface and has a projection on the side thereof. The photovoltaic power generation unit includes a photovoltaic power generation assembly and a groove type mounting bracket of the application. By using the groove type mounting bracket of the application, the flexible photovoltaic assembly can be directly snap-fitted and mounted on the standing seam roof.

## Description

### Technical Field

The present application relates to, but is not limited to, mounting and utilization of a photovoltaic power assembly.

### Background

With the continuous development of new energy utilization technology, distributed photovoltaic power generation technology provides us a more convenient energy source supply. Distributed photovoltaic power generation system occupies a certain sized space. At present, in addition to photovoltaic power stations on the ground, distributed photovoltaic power generation systems are mainly installed on the roof, facade and other surfaces of a building. The weight of photovoltaic power generation system (also called photovoltaic power station) creates a certain weight load on the building to which it is mounted. The weight of photovoltaic power generation system mainly consists of the weights of the photovoltaic assembly (including glass, steel plate, etc.) and the mounting system (including metal bracket, lining plate, etc.).

Existing photovoltaic assemblies are mainly classified into crystalline silicon type, amorphous silicon type, flexible type and other types according to the materials used. Due to the differences in material property and packaging process, photovoltaic assembly products made of crystalline silicon materials or most of amorphous silicon materials are packaged using glass and cannot be bent. Therefore, such photovoltaic assemblies are heavy and sensitive to vibration and sharp stress change. In order to meet the packaging and mounting requirement of such assemblies, a large number of glass packages, metal brackets and counterweights are often required during mounting, resulting in a sharp increase in the weight of photovoltaic power generation system composed of photovoltaic assembly, the mounting system thereof and other components, thus affecting the distributed application range of glass-based crystalline silicon and amorphous silicon photovoltaic assemblies.

Flexible photovoltaic assembly is a new type solar photovoltaic assembly which adopts CIGS (CuInxGa(1-x)Se₂) power generation technology. The advantage of such photovoltaic assembly is that it can be bent and adhered onto other object. After being packaged by using non-metal materials such as ETFE (ethylene-tetra-fluoro-ethylene) copolymer, the flexible photovoltaic assembly can be directly adhered to the facade, curved top surface of a building or other locations of a building. The weight of such assembly is only one third of that of the glass-based crystalline silicon assembly or glass-based amorphous silicon assembly. If the flexible photovoltaic assembly is directly adhered on the building surface, the building surface has to meet some adhering requirements, for example, the area of the adhering surface should at least equal to the minimum area required for mounting the flexible photovoltaic assembly, and the adhering surface needs have a certain flatness, which affect the application range of distributed power generation of the flexible photovoltaic assemblies.

To sum up, the weight of photovoltaic power generation system itself and the requirements that the building surface needs to meet are the factors limiting the distributed solar power generation application.

### Summary

The following is a summary of the subject matters described in detail herein. This summary is not intended to limit the protection scope of the claims.

The present application provides a groove type mounting bracket for a flexible photovoltaic assembly, which is configured for mounting the flexible photovoltaic assembly on a standing seam roof, and comprises a support plate and grooves arranged on two opposite sides of the support plate.

The present application further provides a groove type mounting bracket for a photovoltaic power generation assembly, which is configured for mounting the photovoltaic power generation assembly on a building, and comprises a support plate and grooves, wherein the support plate is configured for mounting the photovoltaic power generation assembly, and the grooves are arranged at the sides of the support plate and suitable for snap-fitting with the vertical members which extend on the surface of the building and have projections on the sides thereof. The photovoltaic power generation assembly may be a flexible photovoltaic assembly. The vertical members extending on the surface of the building and having projections on the sides thereof may be locking seams on the standing seam roof.

The present application further provides a photovoltaic power generation unit which comprises a photovoltaic power generation assembly and the groove type mounting bracket according to this application. The photovoltaic power generation assembly is mounted on a support plate of the groove type mounting bracket. The photovoltaic power generation assembly may be a flexible photovoltaic assembly adhered at the back surface thereof to the support plate. The photovoltaic power generation unit may be configured to be directly snap-fitted onto a standing seam roof.

The present application further provides a method for mounting a photovoltaic power generation assembly on a standing seam roof. The method comprises the following steps: mounting the photovoltaic power generation assembly between two locking seams of the standing seam roof by a groove type mounting bracket; and connecting the photovoltaic power generation assemblies in series or in parallel to complete the connection of a power generation system. The photovoltaic power generation assembly may be a flexible photovoltaic assembly.

By using the groove type mounting bracket and the photovoltaic power generation unit described in the above schemes of the present application, the photovoltaic power generation assembly, such as the flexible photovoltaic assembly, can be mounted on the building surface, such as the standing seam roof. Since the groove type mounting bracket can be directly snap-fitted to the existing structure of the building surface such as the locking seam of the standing seam roof by the grooves without additional supporting structure and the connecting structure being arranged on the building surface, such mounting is very convenient and flexible, the workload is light, and the original roof structure of the building surface such as the standing seam roof will not be damaged. Besides, the disassembling and assembling operation of the groove type mounting bracket is very simple and convenient. Since the flexible photovoltaic assembly is fixed on the support plate of the groove type mounting bracket, a flat surface on the roof is no longer needed, thus the mounting surface will not limit the mounting of the flexible photovoltaic assembly. The distributed photovoltaic power generation system can be established on a building surface with vertical members, such as a standing seam roof. In addition, the groove type mounting bracket is simple in structure and light in weight. The flexible photovoltaic assembly and the groove type mounting bracket apply a reduced load on the building, thus reducing the influence on the building and increasing the mounting and application range of the flexible photovoltaic assembly.

Other aspects will become apparent after reading and understanding the brief description of the drawings and the embodiments of the present application.

### Brief Description of Drawings

The embodiments of the present application and the advantages thereof can be more fully and better understood in view of the following detailed description taken in conjunction with the accompanying drawings. However, the drawings described herein are provided for further understanding the embodiments of the present application and constitute a part of embodiments of the present application. The exemplary embodiments of the present application and the description thereof are used to explain the present application and do not limit the present application. In the figures:
Fig. 1 is a schematic view of an exemplary groove type mounting bracket for a flexible photovoltaic assembly according to embodiment 1 of the present application, the support plate having no holes;
Fig. 2 is an enlarged partial view of the groove in Fig. 1;
Fig. 3 is a schematic structural view of the vertical support rib in Fig. 1;
Fig. 4 is a schematic view of another exemplary groove type mounting bracket for a flexible photovoltaic assembly according to embodiment 1 of the present application, the support plate having holes;
Fig. 5 is a schematic view of an exemplary flexible photovoltaic unit (with a front-mounted junction box) according to embodiment 1 of the present application, which can be mounted on a standing seam roof;
Fig. 6 is a schematic view of another exemplary flexible photovoltaic unit (with a back-mounted junction box) according to embodiment 1 of the present application, which can be mounted on a standing seam roof;
Fig. 7 is a schematic back view of the flexible photovoltaic unit (with a back-mounted junction box) shown in Fig. 6;
Fig. 8 is a schematic view of a groove type mounting bracket for a flexible photovoltaic assembly mounted to a standing seam roof according to embodiment 1 of the present application;
Fig. 9 is a schematic view of a flexible photovoltaic assembly mounted on a groove type mounting bracket according to embodiment 1 of the present application;
Fig. 10 is a schematic view of the overlapped standing seam roof panels;
Fig. 11 is a schematic view of the groove in Fig. 2 being snap-fitted with the locking seam;
Fig. 12 is a schematic view of an arc-shaped section, instead of a V-shaped section in Fig. 2, of the groove being snap-fitted with the locking seam;
Fig. 13 is a schematic view of the groove of the groove type mounting bracket being snap-fitted with the vertical member extending on a building surface according to embodiment 3 of the present application;
Fig. 14 is a schematic view of the vertical members extending from the building surface according to the embodiment 3 of the present application, the vertical members being staggered in the transverse and longitudinal directions;
Fig. 15 is a schematic view of the groove of the groove type mounting bracket being snap-fitted with the vertical member on the building surface according to embodiment 4 of the present application, in which a single side of the vertical member is provided with a projection;
Fig. 16 is a flowchart of a method for mounting the flexible photovoltaic assembly according to embodiment 7 of the present application;
Fig. 17 is a flowchart of an exemplary method for mounting a flexible photovoltaic assembly according to embodiment 7 of the present application;
Fig. 18 is a flowchart of another exemplary method for mounting a flexible photovoltaic assembly according to embodiment 7 of the present application;
Fig. 19 is a schematic view of mounting a flexible photovoltaic assembly on a standing seam roof according to the method shown in Fig. 18.

### Reference numerals:

100, 100', 100" -- groove type mounting bracket
1, 1', 1" -- support plate
10 -- weight reducing hole
11 -- mounting opening
12 -- second wire passing hole
2, 2', 2" -- support rib
21 -- first wire passing hole
3, 3', 3" -- groove
30 -- lower bent edge
31 -- V-shaped section
32, 32', 32" -- reinforcing section
33 -- arc-shaped section
34, 34' -- U-shaped section
4 -- flexible spacer
5 -- flexible photovoltaic assembly
50 -- assembly body
51 -- junction box
510, 511 -- wire
7 -- standing seam roof
70 -- locking seam
71 -- crest
72 -- standing seam roof panel
73 -- support seat
74 -- projection
80, 80'-- vertical member
81, 81'-- projection

### Detailed Description

The present application will be further explained by describing the embodiments with reference to the accompanying drawings.

Embodiments of the present application will be described in detail below and examples of the embodiments are shown in the accompanying drawings. Throughout the drawings the same or similar reference numbers denote the same or similar elements or elements having the same or similar functions. The embodiments described below with reference to the accompanying drawings are exemplary, merely used to explain the present application, and cannot be construed as limiting the present application.

In the description of this application, the terms 'upper', 'lower', 'inner', 'outer', 'axial direction', 'outer side', 'opposite side' and the like indicate relative orientations or positions based on the orientations or positions shown in the drawings, merely to facilitate the description of this application and to simplify the description, and such terms do not intend to indicate or imply that the structure referred to has a particular orientation or is constructed and operated in a particular orientation, and therefore cannot be construed as limiting the application.

### Embodiment 1

In this application, the groove type mounting bracket may also be referred to as a mounting groove type bracket.

The flexible photovoltaic assembly in this embodiment includes a CIGS thin film photovoltaic assembly, an amorphous silicon thin film photovoltaic assembly, an amorphous silicon germanium thin film photovoltaic assembly, a cadmium telluride thin film photovoltaic assembly, a gallium arsenide thin film photovoltaic assembly, or an organic thin film photovoltaic assembly.

The material of the groove type mounting bracket of the flexible photovoltaic assembly of this embodiment is an elastic material. In an example, the material of the groove type mounting bracket is metal, including aluminum, aluminum alloy, stainless steel, copper, copper alloy, galvanized steel plate, etc.

The shape of groove corresponds to the shape of the standing seam of a metal roof panel and the groove can be interference fitted with the standing seam of the metal roof panel.

In order to make the goals, technical schemes and advantages of this application clearer and more explicit, the embodiments thereof will be further explained with reference to the attached drawings.

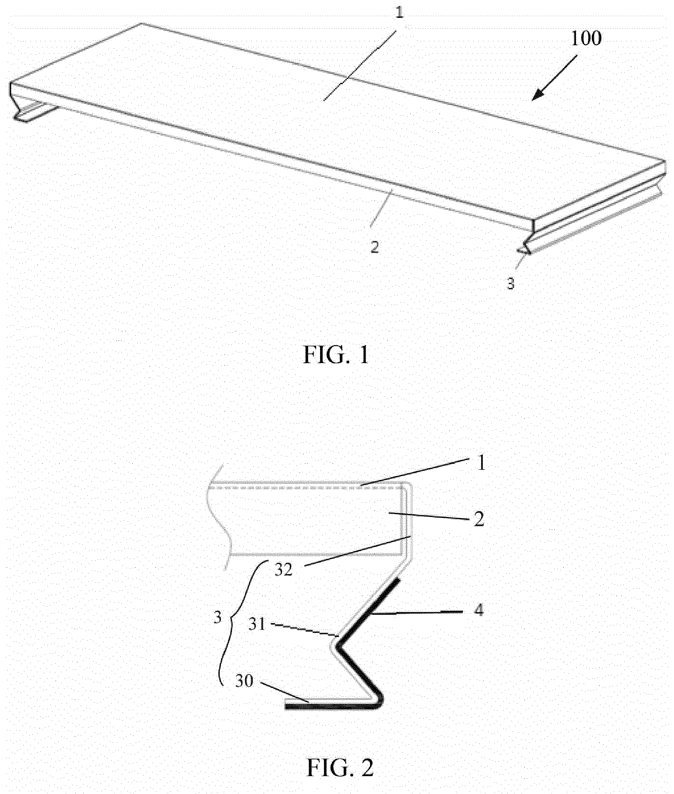

As shown in Fig. 1, a groove type mounting bracket 100 for a flexible photovoltaic assembly includes a support plate 1, grooves 3 and a vertical support rib 2. The support plate 1 is rectangular shaped. The support rib 2 is arranged along the direction of the long side of the support plate 1. The groove 3 is arranged on the short side of the support plate 1. The length of the support plate 1 is an integer multiple of the width between the crests of the standing seam roof.

The grooves 3 are arranged on the opposite two sides of the support plate and can snap-fit with two locking seams on the standing seam roof. In an example, the grooves 3 may be arranged on the two long sides of the support plate 1. Correspondingly, the spacing between the two sides of the support plate provided with the grooves is an integer multiple of the width between the crests of the standing seam roof. For example, when the grooves 3 are arranged on the short sides of the support plate 1, the length of the support plate 1 is an integer multiple of the width between the crests of the standing seam roof, and when the grooves 3 are arranged on the long sides of the support plate 1, the width of the support plate 1 is an integer multiple of the width between the crests of the standing seam roof.

As shown in Fig. 2, the outer side of the groove 3 that is in contact with the locking seam of the standing seam roof is provided with a flexible spacer 4 for isolating and anti-friction. The flexible spacer 4 and the groove 3 are connected by adhesive or countersunk rivet.

The flexible spacer 4 is made of rubber, resin, fiber or plastic.

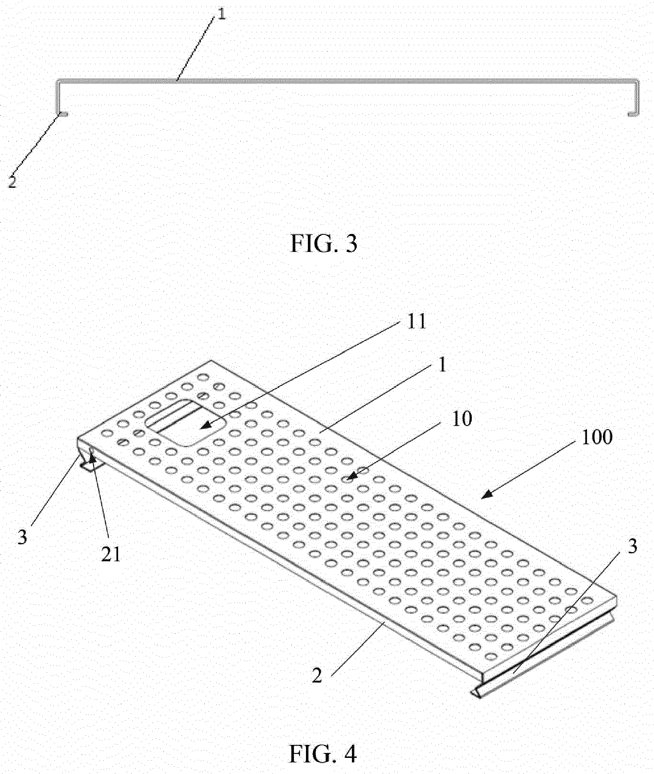

A vertical support rib 2 is shown in Fig. 3. The long side of the support plate 1 needs to be bent into the form of a vertical support rib 2 as shown in Fig. 3 to provide vertical rigidity.

As shown in Fig. 4, circular holes 10 are evenly distributed on the support plate 1, and the total area occupied by the circular holes is 24% of the total area of the support plate 1. In this application, the circular hole 10 is also referred to as a weight reducing hole.

The support plate 1 is provided with a square hole 11 for accommodating the junction box of the flexible photovoltaic assembly. A junction box provided on the back of the flexible photovoltaic assembly may properly pass through the square hole.

A side of the support rib 2 close to the short side of the support plate 1 is provided with a hole 21 through which the wire passes. In this application, the hole 21 through which the wire passes is also referred to as a first wire passing hole.

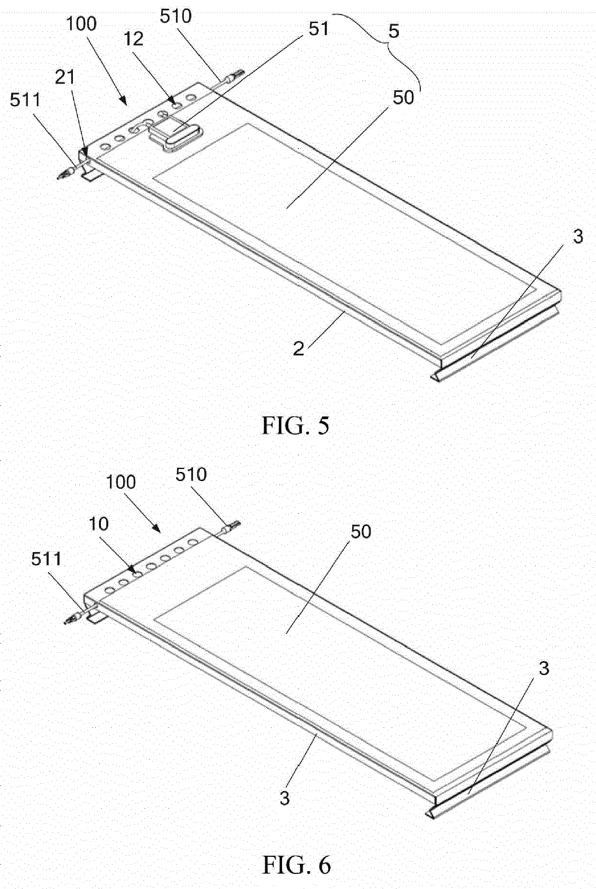

As shown in Fig. 5, a flexible photovoltaic unit installed on a standing seam roof is provided. The flexible photovoltaic unit includes the above-mentioned groove type mounting bracket 100 and a flexible photovoltaic assembly 5 which is adhered to the support plate 1 and has a same size as the support plate 1.

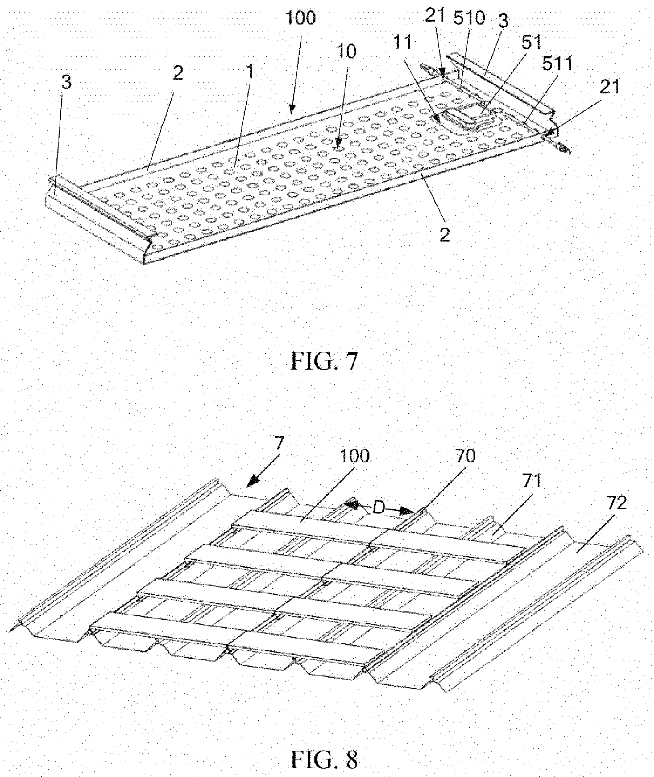

As shown in Figs. 6 and 7, the junction box 51 of the flexible photovoltaic assembly 5 is on the back side, and the support plate 1 is provided with a square hole 11 for accommodating the junction box 51. The junction box 51 includes two wires 510, 511, one of which is a positive wire and the other one is a negative wire, which respectively pass through the holes 21 in the two support ribs 2.

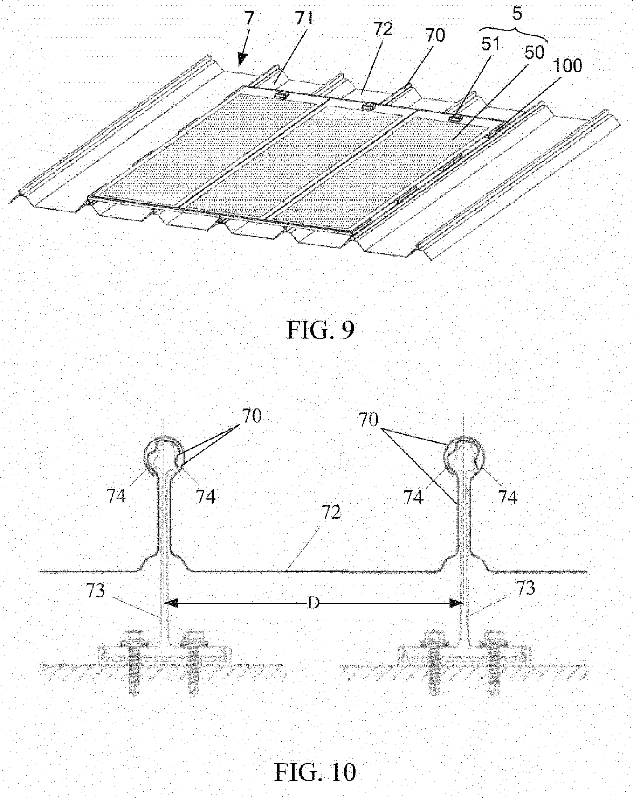

As shown in Figs. 8 and 9, a method for mounting a flexible photovoltaic assembly 5 onto a standing seam roof 7 includes:
Step (1), arranging the groove type mounting bracket 100 for the flexible photovoltaic assembly 5 at set intervals, and snap-fitting the groove type mounting bracket 100 between two locking seams 70 on the standing seam roof 7;
Step (2), forming a grid type platform on the standing seam roof 7 by using the support plate 1, and mounting and adhering the flexible photovoltaic assembly 5 on the bottom plate (the support plate 1 of the groove type mounting bracket 100) in a discontinuous manner to form a monolithic photovoltaic array;
Step (3), connecting the flexible photovoltaic assemblies 5 in series or in parallel to complete the connection of the power generation system.

A method for mounting the flexible photovoltaic unit mounted on the standing seam roof 7 includes:
Step (1), directly snap-fitting the flexible photovoltaic unit mounted on the standing seam roof 7 between two locking seams 70 on the standing seam roof 7;
Step (2), connecting the flexible photovoltaic assemblies 5 in series or in parallel to complete the connection of the power generation system;
Step (3), coating silicone structural adhesive at the contact position of the groove 3 and the standing seam 70 for fixing.

Based on the above, this embodiment provides a method suitable for mounting the flexible photovoltaic assembly by providing the structural design of the groove type mounting bracket for the flexible photovoltaic assembly, and utilizing the properties of the flexible photovoltaic assembly such as flexibility, reliability in packaging, strong stress change resistance and the like. Because the alloy plate is light in weight, the total weight of the mounting system is only 20% to 25% of that of a traditional bracket mounting system. Besides, the limitation of the building surface on the mounting of the flexible photovoltaic assembly is well avoided, the quick disassembly and assembly of the flexible photovoltaic assembly are realized, and the application flexibility is improved.

### Embodiment 2

The embodiment relates to a groove type mounting bracket which is used for mounting a flexible photovoltaic assembly on a standing seam roof.

Fig. 10 is a schematic view of the standing seam roof panel 72 after being overlapped and connected. As shown in the figure, the standing seam roof panel 72 is generally formed by rolling and compressing a thin metal plate, and includes a bottom plate and two locking seams (also called overlapping edges and standing seams) 70 respectively extending upward from two sides of the bottom plate. The two locking seams 70 are supported by support seats 73 fixed on the roof structure, and the ends of the two locking seams 70 form hook-type crimping edges which can engage with each other. In the overlapping process (also called the seam locking process), the ends of the two locking seams 70 of the adjacent standing seam roof panel 72 are engaged by means of a tool to form a tight connection. A plurality of standing seam roof panels 72 are overlapped with each other to form the standing seam roof 7. The locking seams 70 on both sides of the standing seam roof panel 72 protrude above the entire standing seam roof 7 to form crests 71, and the spacing between adjacent crests 71 is D.

As shown in Fig. 10, the cross section of the end of the locking seams (after being engaged) 70 on the standing seam roof 7 has a substantially circular shape, so that the locking seam 70 has projections 74 on both sides. As shown in Fig. 8, as a whole, the locking seams 70 extend in the longitudinal direction of the standing seam roof 7 and are arranged at intervals.

As shown in Figs. 1-3, an example of this embodiment provides a groove type mounting bracket 100, which includes a support plate 1 and grooves 3. The support plate 1 is arranged to mount a flexible photovoltaic assembly 5. The groove 3 is arranged on a side of the support plate 1, and configured for snap-fitting with the locking seam 70 on a standing seam roof.

In this embodiment, the flexible photovoltaic assembly 5 is mounted on the standing seam roof 7 by the groove type mounting bracket 100. Since the groove type mounting bracket 100 can be directly snap-fitted to the existing locking seams 70 of the standing seam roof 7 by the grooves 3 without additional supporting structure and the connecting structure being arranged on the standing seam roof 7, such mounting is very convenient and flexible, the workload is light, and the original roof structure of the standing seam roof 7 will not be damaged. Besides, the disassembling and assembling operation of the groove type mounting bracket 100 is also very simple and convenient, and thus the quick disassembling and assembling of the flexible photovoltaic assembly 5 is realized. Since the flexible photovoltaic assembly is fixed on the support plate 1 of the groove type mounting bracket 100, a flat adhering surface on the roof is no longer needed, thus the mounting surface will not limit the mounting of the flexible photovoltaic assembly. The flexible photovoltaic assembly can be applied to a building surface with protruding members, such as a standing seam roof, to construct a distributed photovoltaic power generation system. In addition, the groove type mounting bracket 100 is simple in structure and light in weight. The flexible photovoltaic assembly 5 and the groove type mounting bracket 100 apply a reduced load on the standing seam roof 7 and the building structure, thus reducing the influence on the building and increasing the mounting and application range of the flexible photovoltaic assembly 5.

In this embodiment, the groove type mounting bracket 100 is a one-piece structure, and its overall structural strength is high. In this embodiment, the groove type mounting bracket 100 is made of the same material as the locking seam 70, so that the thermal expansion and contraction effects of the groove type mounting bracket 100 and the standing seam roof panel 72 are approximately the same, which is beneficial to the reliable connection between the groove type mounting bracket 100 and the standing seam roof panel 72. In one example, the groove type mounting bracket 100 is made of aluminum plate, and the surface of the aluminum plate is anodized. In another example, the groove type mounting bracket 100 is made of aluminum-zinc alloy coated steel plate, and the amount of coated zinc is not less than 150 grams per square meter. In addition, other metal plates such as aluminum alloy, stainless steel, copper, copper alloy, galvanized steel plate may be used for the groove type mounting bracket 100.

In this embodiment, the upper surface of the support plate acts as a surface to which the flexible photovoltaic assembly is adhered. In the example shown in Fig. 1, the support plate 1 is a one-piece plate, but it can otherwise be formed by joining several pieces. In this embodiment, the support plate 1 is rectangular shaped, and the range of length × width can be 2m × 0.4m to 10m × 1m. That is, the length range of the support plate 1 is 2m to 10m and the width range is 0.4m to 1m. In some examples, the length × width of the support plate 1 is 4m × 0.5m, 2.1m × 0.5m, or 6m × 0.5m. The support plate 1 may have other shapes, for example, the support plate 1 includes two parallel sides and two arc-shaped sides connected between the two parallel sides, and the middle portions of the two opposite arc-shaped sides may be narrowed or widened relative to the two parallel sides. As another example, the support plate can be trapezoidal shaped, etc.

In another example of this embodiment shown in Fig. 4, the support plate 1 is provided with weight reducing holes 10. On one hand, the weight reducing holes 10 can reduce the weight of the bracket 100, thus reducing the load applied to the building when the flexible photovoltaic assembly 5 is mounted. On the other hand, the weight reducing holes 10 can be used as heat dissipation holes when the flexible photovoltaic assembly 5 is mounted on the support plate 1, which is beneficial to the heat dissipation when the flexible photovoltaic assembly 5 is working. The weight reducing holes 10 shown in Fig. 4 are circular through holes and distributed at regular intervals (e.g., evenly distributed) on the support plate 1. It should be understood that the weight reducing holes 10 may be holes with other shapes, such as rectangular holes, elliptical holes or the like. The weight reducing hole can be a through hole or a blind hole. The total area occupied by the weight reducing holes 10 provided in the support plate 1 can be set to 20% to 60% (e.g., 24%) of the area of the upper surface of the support plate 1, so as to reduce the weight of the groove type mounting bracket 100 while meeting the support strength requirement of the support plate 1. However, the total area occupied by the weight reducing holes 10 provided in the support plate 1 should be set according to actual needs and is not limited to the above range. By providing the weight reducing holes on the support plate, the weight of the groove type mounting bracket can be greatly reduced, thus reducing the weight of the photovoltaic system itself, and making the photovoltaic system suitable for more occasions.

In the example shown in Fig. 4, a mounting opening 11 is also formed on the support plate 1, and provided to accommodate the junction box of the flexible photovoltaic assembly. The shape of the mounting opening 11 corresponds to the shape of the junction box. The rectangle shown in the figure represents the square hole, but it can otherwise be circular or other shapes. By providing a mounting opening 11 on the support plate 1 for accommodating the junction box of the flexible photovoltaic assembly, the back surface of the flexible photovoltaic assembly 5 can be completely contacted with and attached to the surface of the support plate 1 of the groove type mounting bracket 100, thereby facilitating the mounting and fixing of the flexible photovoltaic assembly. In another example of this embodiment, the junction box of the flexible photovoltaic assembly mounted on the support plate 1 is a front-mounted type, and the groove type mounting bracket of this example is the same as the groove type mounting bracket 100 shown in Fig. 4, except that it does not have a mounting opening 11 on the support plate 1, and instead the weight reducing holes 10 are evenly distributed on the entire surface of the support plate 1.

In the example shown in Fig. 1, the support plate 1 of the groove type mounting bracket 100 is rectangular shaped, and two grooves 3 are provided on two opposite sides of the support plate 1 and configured to snap-fit with two locking seams 70 so as to fix the groove type mounting bracket 100. The distance between the two grooves 3 can be set to be an integer multiple of the spacing D between adjacent crests 71 of the standing seam roof 7, see Fig. 8. It should be noted that this distance is not required to be very precise as long as it can be ensured that the grooves 3 can be directly snap-fitted with the locking seams 70. Although the two grooves 3 shown in the figure are provided on the two opposite short sides of the support plate 1, they can be provided on the two opposite long sides of the support plate 1 as well. The length or width of the support plate is set to be an integer multiple of the spacing D between adjacent crests of the standing seam roof, and the support plate can be directly snap-fitted between two locking seams, which means no other process is needed and thus it is very convenient.

In this embodiment, the groove 3 is integrally formed with the support plate 1 and is bent downward from the side of the support plate 1, so that it is convenient to manufacture and install. When the two grooves 3 are provided at the edges of the short sides of the support plate 1, the length of the support plate 1 (the distance between the two short sides) can be set to an integer multiple of the spacing D between adjacent crests 71 of the standing seam roof 7. When the grooves 3 are provided at the edges of the long sides of the support plate 1, the width of the support plate 1 (the distance between the two long sides) is set to an integer multiple of the spacing D. In other embodiments, the groove 3 is provided on the side of the support plate 1, or may be provided near the edge of the support plate 1, not necessarily just at the edge of the side. The groove 3 may otherwise be a component separated from the support plate 1 and connected to the support plate 1 by screwing, snapping or the like.

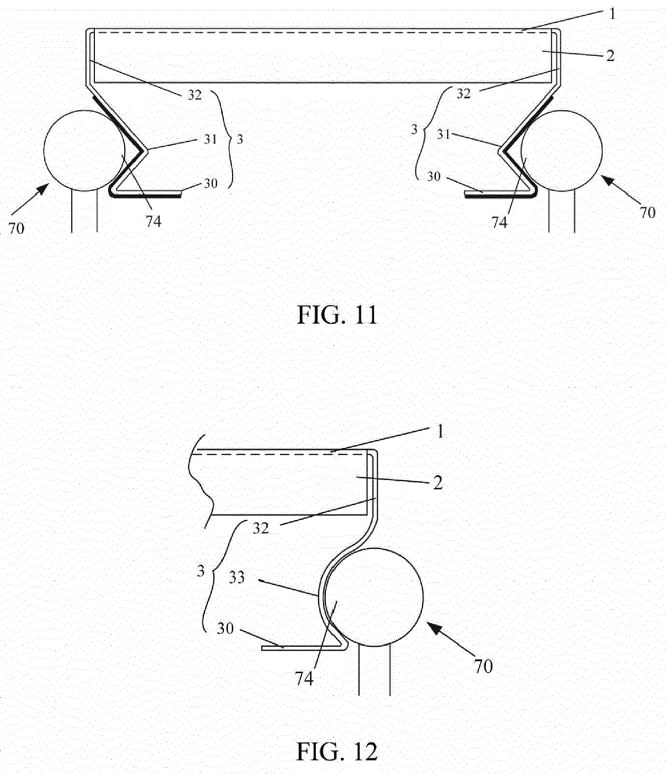

In this embodiment, the groove 3 includes at least a groove-shaped section, and the shape of which is set to match the shape of the projection on the side of the locking seam. The groove openings of the two grooves 3 (i.e., the openings of the groove-shaped sections) both face toward the outside of the groove type mounting bracket 100. In the example shown in Figs. 2 and 11 (for purpose of illustration, Fig. 11 only draws the outline of the end of the locking seam 70 which is shown as a circular surface), the groove-shaped sections of the two grooves 3 are both V-shaped sections 31, the groove openings are the openings of the V-shaped sections 31 which both face toward the outside of the groove type mounting bracket 100. The two V-shaped sections 31 are respectively cooperated with opposite projections on the sides of the two locking seams 70 so as to snap-fit the grooves 3 and the two locking seams 70, thus snap-fitting the groove type mounting bracket 100 between the two locking seams 70. When being snap-fitted, the projection 74 on the side of the locking seam 70 enters the V-shaped section 31 of the groove 3 and presses against the V-shaped section 31, thus limiting the upward and downward movement of the groove 3 for firm clamping. In this embodiment, the groove 3 further includes a reinforcing section 32 disposed above the V-shaped section 31 and a lower bent edge 30 which is disposed below the V-shaped section 31 and extends inwardly. The reinforcing section 32 is connected to the support plate 1 to enhance the structural strength of the groove 3. The lower bent edge 30 can also enhance the structural strength of the groove 3 and improve the stability of the snap-fitting. It should be noted that if the strength of the plate material constituting the groove 3 is sufficient, for example, if a thicker metal plate is used, one or both of the reinforcing section 32 and the lower bent edge 30 can be omitted. In another example of this embodiment, as shown in Fig. 12, the groove-shaped section of the groove 3 is an arc-shaped section 33, and such groove 3 is also suitable for snap-fitting with the locking seam 70.

In the example shown in Fig. 2, the groove type mounting bracket 100 further includes a flexible spacer 4 installed at a portion of the groove 3 which intends to be in contact with the locking seam 70 of the standing seam roof 7. The flexible spacer 4 separates the groove 3 from the locking seam 70, which can prevent the groove 3 and the locking seam 70 from being damaged due to friction. The flexibility of the flexible spacer can also improve the stability of the snap-fitting. In Fig. 2, the flexible spacer 4 is mounted on the V-shaped section 31 and the lower bent edge 30 of the groove 3. The flexible spacer 4 and the groove 3 may be connected by adhesive or by countersunk rivet, but the present application is not limited thereto. The material of the flexible spacer 4 may be, but is not limited to, rubber, resin, fiber, or plastic. A flexible spacer made of such material is light in weight and low in cost. In this application, the flexible spacer 4 can be omitted.

In this embodiment, the groove type mounting bracket 100 further includes a support rib 2 arranged on the support plate 1. The support rib 2 and the groove 3 are respectively located on different sides of the support plate 1. As shown in Figs. 1, 3, and 4, two support ribs 2 are provided on opposite sides of the support plate 1 on which no groove 3 is provided. In the illustrated example, the support ribs 2 are provided on the long sides of the rectangular support plate 1. The support ribs 2 can enhance the structural strength of the support plate 1 to ensure that the support plate 1 can firmly fix the flexible photovoltaic assembly 5. In the example shown in Fig. 3, the support rib 2 is a vertical support rib formed by bending the long side of the support plate 1 downward, so as to provide vertical rigidity to the support plate 1. It should be understood that the support rib 2 may take other forms such as a bar arranged on the lower surface of the support plate 1. In addition, if the structural strength of the support plate 1 itself is sufficient, the support rib 2 may be omitted.

In the example shown in Fig. 4, the side of the support rib 2 close to the mounting opening 11 is further provided with a first wire passing hole 21. The first wire passing hole 21 is arranged to allow the wire connected to the photovoltaic power generation assembly to pass through and route the wire along a predetermined path, so as to avoid insulation layer of the wire being damaged, premature aging and the like caused by random routing.

### Embodiment 3

This embodiment relates to a groove type mounting bracket.

In this embodiment, the flexible photovoltaic assembly is mounted on the building surface through the groove type mounting bracket, and the building surface can be either a roof or a wall. In addition, the material of the building surface can be metal material or non-metallic material. The building surface has vertical members protruding upward from the building surface and extending over the building surface. In this application, the vertical member refers to the building member protruding above the building surface, and the locking seam of embodiment 1 is one type of such building member. In this embodiment, the vertical member extending on the building surface includes two sides, one or both of which has projection(s). The projection may be arranged at the end of the side of the vertical member or at other positions on the side of the vertical member. The shape of the cross-section of the projection may be arc, rectangle, triangle, etc.

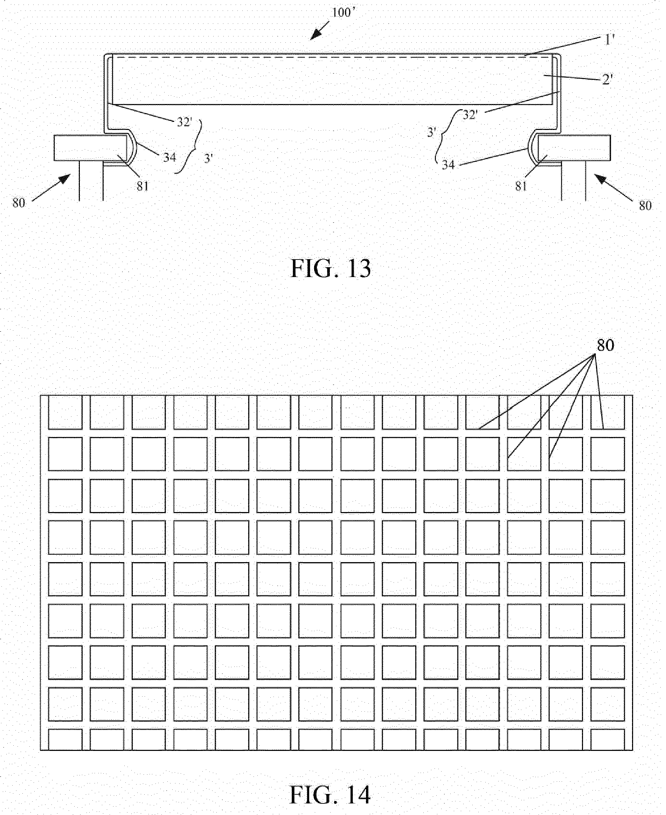

In an example of this embodiment, as shown in Fig. 13, both sides of the vertical member 80 extending on the building surface are provided with projections 81, and the cross section of the projection 81 has a substantially rectangular shape. The groove type mounting bracket 100' of this embodiment includes a support plate 1' and grooves 3'. The support plate 1' is arranged to install a photovoltaic power generation assembly. The grooves 3' are arranged at the sides of the support plate 1', and suitable for snap-fitting with the vertical members 80 extending on the building surface. The groove type mounting bracket 100' may further include a support rib 2'. The arrangement of the support plate 1' and the support rib 2' may be the same as that of any support plate 1 and support rib 2 described in embodiment 1.

As shown in Fig. 13, in order to match the shape of the projection 81 on the side of the vertical member 80, the groove-shaped section of the groove 3' in this embodiment is an U-shaped section 34. The openings of the U-shaped sections of the two grooves 3' both face toward the outside of the groove type mounting bracket 100', so as to respectively snap-fit with two opposite projections 81 on the sides of the two vertical members 80 spaced apart. A reinforcing section 32' is provided above the U-shaped section 34, but there is no lower bent edge. It is easy to understand that the shape of the groove-shaped section of the groove 3' is not limited to a certain specific shape, as long as it matches the shape of the projection on the side of the vertical member 80 extending from the building surface and a reliable snap-fitting can be achieved. For example, the groove-shaped section can otherwise be an arc-shaped section, a V-shaped section, etc.

In an example of this embodiment, the vertical members 80 extend in both longitudinal and transverse directions on the building surface and are staggered. For example, in the top view of the roof shown in Fig. 14, the vertical members 80 extending on the roof are arranged in a rectangular grid shape. Therefore, the grooves 3' can be arranged on two or three or four sides of the groove type mounting bracket 100' and snap-fitted with two or three or four vertical members at the periphery of the rectangular grid. It is easy to understand that if the vertical members extending on the building surface form a grid with another shape, such as a triangular grid, a pentagonal grid, a hexagonal grid, etc., the shape of the support plate 1' and the position and number of the grooves 3' can be changed accordingly to meet the actual mounting requirements. For example, the support plate 1' may be triangular-shaped, and the groove 3 may be provided on each of the three sides of the support plate 1'. As another example, the support plate 1' may be hexagonal-shaped, and two, four or six grooves 3 may be provided on one, two or three pairs of opposite sides of the support plate 1' and so on.

It is easy to understand that in this embodiment, the flexible photovoltaic assembly is mounted on building surface having vertical members by the groove type mounting bracket. Since the groove type mounting bracket can be directly snap-fitted to the existing vertical members of the building surface by the grooves without additional supporting structure and the connecting structure being arranged, such mounting is very convenient and flexible, the workload is light, and the original structure of the building surface will not be damaged. Besides, the disassembling and assembling operation of the groove type mounting bracket is also very simple and convenient. A flat surface on the building surface is no longer needed, thus the mounting surface will not limit the mounting of the flexible photovoltaic assembly. The distributed photovoltaic power generation system can be established on a building surface with vertical members. In addition, the groove type mounting bracket is simple in structure and light in weight, and thus applying a reduced load on the standing seam roof and the building structure, reducing the influence on the building and increasing the mounting and application range of the flexible photovoltaic assembly.

### Embodiment 4

This embodiment relates to a groove type mounting bracket.

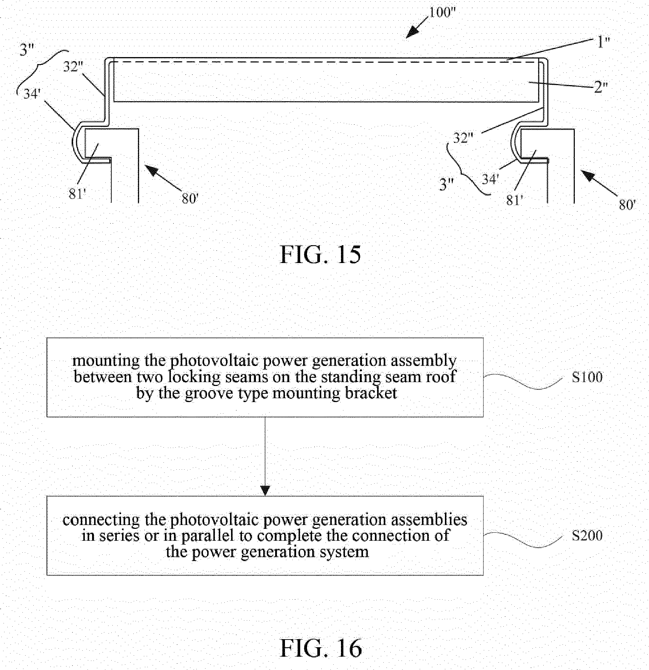

In this embodiment, only one side of the vertical member 80' extending on the building surface has a projection 81', and the shape of the cross-section of the projection 81' can be arc, triangle, rectangle, etc. For example, in Fig. 15, the cross-section has a rectangular shape. The groove type mounting bracket 100" of this embodiment is basically the same as the groove type mounting bracket 100' of embodiment 3, except that in two grooves 3" arranged on two opposite sides of the groove type mounting bracket 100", the groove opening of one groove 3" (the opening of the U-shaped section of the groove 3" on the right in the figure) faces toward the outside of the groove type mounting bracket 100" and the groove opening of the other groove 3" (the opening of the U-shaped section of the groove 3" on the left in the figure) faces toward the inside of the groove type mounting bracket 100". Although both of the groove openings face toward right in the figure, one of the two groove openings faces toward the outside and the other faces toward the inside with respect to the groove type mounting bracket 100", which is different from the previous embodiments.

During mounting, as shown in Fig. 15, since the projections 81' on the sides of the vertical members 80' both face toward left in the figure, the two grooves 3" can respectively engage with two vertical members 80' spaced apart, thereby snap-fitting the groove type mounting bracket 100" between the two vertical members 80'. If the groove openings of the two grooves 3" face toward the outside of the groove type mounting bracket 100", the mounting cannot be achieved. It is easy to understand that when the shape of the projection 81' on the side of the vertical member 80' varies, the groove-shaped section of the groove 3" of this embodiment may be a section having a different shape, such as a V-shaped section, an arc-shaped section, and the like.

In the above embodiment, if the vertical members extending on the building surface are made of a non-metallic material, the groove type mounting bracket may be made of a non-metallic material such as plastic.

It is easy to understand that in another embodiment, the groove openings of the grooves arranged on opposite sides of the groove type mounting bracket may face toward the inside of the groove type mounting bracket so as to meet the mounting requirements of different building surface structures. For example, the projection is formed on one of the sides of the vertical member extending on the building surface, but the sides, having projections, of the vertical members in two adjacent columns are different.

### Embodiment 5

This embodiment relates to a flexible photovoltaic unit comprising a flexible photovoltaic assembly and a groove type mounting bracket, in which the junction box of the flexible photovoltaic assembly is a front-mounted type.

The flexible photovoltaic assembly may be any one of a CIGS thin film photovoltaic assembly, an amorphous silicon thin film photovoltaic assembly, an amorphous silicon germanium thin film photovoltaic assembly, a cadmium telluride thin film photovoltaic assembly, a gallium arsenide thin film photovoltaic assembly, or an organic thin film photovoltaic assembly.

The flexible photovoltaic assembly 5 includes an assembly body 50 that is flexible and has a function of photovoltaic power generation, and a junction box 51 that can be disposed on the front side or back side of the assembly body 50. When the junction box 51 is disposed on the front side of the assembly body 50, it is called a front-mounted junction box, and when the junction box 51 is disposed on the back side of the assembly body 50, it is called a back-mounted junction box. This embodiment relates to a flexible photovoltaic assembly 5 with a front-mounted junction box 51.

In this embodiment, the groove type mounting bracket 100 as shown in Fig. 4 is used. The flexible photovoltaic assembly 5 is fixed at the back side thereof to the support plate 1 of the groove type mounting bracket 100 to obtain the flexible photovoltaic unit of this embodiment, as shown in Fig. 5. In one example, the back side of the flexible photovoltaic assembly 5 is adhered to the upper surface of the support plate 1 in a simple, convenient and efficient manner. However, in other examples, other approaches can be used for fixing the flexible photovoltaic assembly 5 to a flat surface.

There is no interference between the junction box 51 arranged on the front side of the flexible photovoltaic assembly 5 and the support plate 1. The mounting opening in the support plate 1 for receiving the junction box 51 can be omitted. Thus, on the basis of the groove type mounting bracket 100 shown in Fig. 4, a mounting opening 11 on the support plate 1 may be omitted, the weight reducing holes 10 are evenly distributed on the entire surface of the support plate 1, thereby the groove type mounting bracket used in another example of this embodiment is obtained, and the flexible photovoltaic unit obtained by using such groove type mounting bracket is shown in Fig. 5. In yet another example of this embodiment, the flexible photovoltaic unit may adopt the groove type mounting bracket 100 shown in Fig. 1.

The junction box 51 is usually connected with two wires 510, 511, one of which is a positive wire and the other is a negative wire. The two wires 510, 511 can be connected in advance or can be connected during mounting. In this embodiment, the two support ribs 2 of the groove type mounting bracket 100 are provided with first wire passing holes 21 to allow the wires 510 and 511 to pass through, so as to connect the flexible photovoltaic assemblies 5 e.g. in series or in parallel, and thus form a photovoltaic power generation system. However, the first wire passing hole 21 can be omitted, and the wires 510 and 511 can be routed under the support ribs 2. As shown in Fig. 5, the first wire passing holes 21 on the two support ribs 2 are both arranged on the side close to the junction box 51, and thus the routing path of the wires is the shortest, facilitating the connection of the wires. The positive and negative wires 510, 511 respectively pass through the wire passing holes formed in the two support ribs 2 to facilitate connecting the adjacent flexible photovoltaic assemblies e.g. in series or in parallel.

Since the junction box 51 is a front-mounted type, the wires 510, 511 can first pass through one or two weight reducing holes 10 provided on the side of the support plate 1 close to the junction box 51 and extend below the support plate 1, and then respectively pass through the first wire passing holes 21 on the two support ribs 2. The one or two weight reducing holes 10 provided on the side of the support plate 1 may also be referred to as the second wire passing holes 12. In another example where the support plate 1 of the groove type mounting bracket is not provided with the weight reducing holes 10, a second wire passing hole 12 may be additionally provided on the side of the support plate 1 close to the junction box 51. In the case that the junction box 51 is arranged on the front side of the flexible photovoltaic assembly 5, by providing the second wire passing hole 12 on the support plate 1, the wire which enters or exits the junction box 51 passes through the wire passing hole formed on the support plate, so that the wire can be routed in the groove type mounting bracket without affecting the surface of the flexible photovoltaic assembly, which is beneficial in terms of light absorbing and aesthetics.

In the example shown in Fig. 5, the size of the flexible photovoltaic assembly 5 (i.e., the area of the back surface of the assembly body 50) is slightly smaller than the size of the support plate (i.e., the area of the upper surface of the support plate 1) to facilitate routing. However, the size of the flexible photovoltaic assembly 5 may otherwise be equal to the size of the support plate. In this case, hooks, loops or other structures may be provided on the outer side of the support rib 2 to contain the wire.

### Embodiment 6

This embodiment relates to a flexible photovoltaic unit, in which the junction box of the flexible photovoltaic assembly is a back-mounted type.

This embodiment uses the groove type mounting bracket 100 as shown in Fig. 4. A mounted structure of the flexible photovoltaic assembly 5 and the groove type mounting bracket 100 is shown in Figs. 6 and 7. When the back surface of the flexible photovoltaic assembly 5 is fixed to, such as adhered to, the support plate 1, in order to make way for and receive the junction box 51, the support plate 1 is provided with a mounting opening 11 for receiving the junction box 51. During mounting, the junction box 51 passes through the mounting opening 11 to avoid interference with the support plate 1. The side of the two support ribs 2 close to the junction box 51 is provided with first wire passing holes 21 through which the positive and negative wires 510, 511 connected to the junction box 51 pass respectively so as to achieve electrical connection between the flexible photovoltaic assemblies 5 and thus construct a photovoltaic power generation system. Although the mounting opening 11 shown in the figure is a square through hole, it should be understood that the shape of the mounting opening 11 is not limited to a square shape as long as mounting opening can make way for and receive the junction box.

In this embodiment, the size of the flexible photovoltaic assembly 5 may be less than or equal to the size of the support plate 1.

It should be noted that each of the above embodiments is explained with reference to the mounting of the flexible photovoltaic assembly, but other types of photovoltaic power generation assemblies can also be installed on the building surface such as the standing seam roof by using the groove type mounting bracket of this application. These building surfaces have vertical members extending thereon and the side of the vertical member is provided with a projection, which can be engaged with the groove. The flat surface of the support plate can be used to install other types of photovoltaic power generation assemblies. Accordingly, the unit including the photovoltaic power generation assembly and the groove type mounting bracket may be referred to as a photovoltaic power generation unit, and the flexible photovoltaic units of the above embodiments are photovoltaic power generation units suitable for direct snap-fitting on the standing seam roof.

### Embodiment 7

This embodiment relates to a method for mounting a photovoltaic power generation assembly, in which the flexible photovoltaic assembly is mounted to a standing seam roof through a groove type mounting bracket.

The method for mounting the photovoltaic power generation assembly on the standing seam roof of this embodiment is shown in Fig. 16, and includes the following steps:
S100, mounting the photovoltaic power generation assembly between two locking seams on the standing seam roof by the groove type mounting bracket;
the groove type mounting bracket of this embodiment can be any of the groove type mounting brackets described in the previous embodiments;
S200, connecting the photovoltaic power generation assemblies in series or in parallel to complete the connection of the power generation system.

In the two examples of this embodiment, the photovoltaic power generation assembly is a flexible photovoltaic assembly, and step S100 is implemented in different ways. In the first example, the groove type mounting bracket is first snap-fitted between two locking seams of the standing seam roof, and then the flexible photovoltaic assembly is mounted on the support plate of the groove type mounting bracket. In the second example, the flexible photovoltaic assembly is first installed on the support plate of the groove type mounting bracket to form a flexible photovoltaic unit, and then the groove type mounting bracket is snap-fitted between the two locking seams of the standing seam roof.

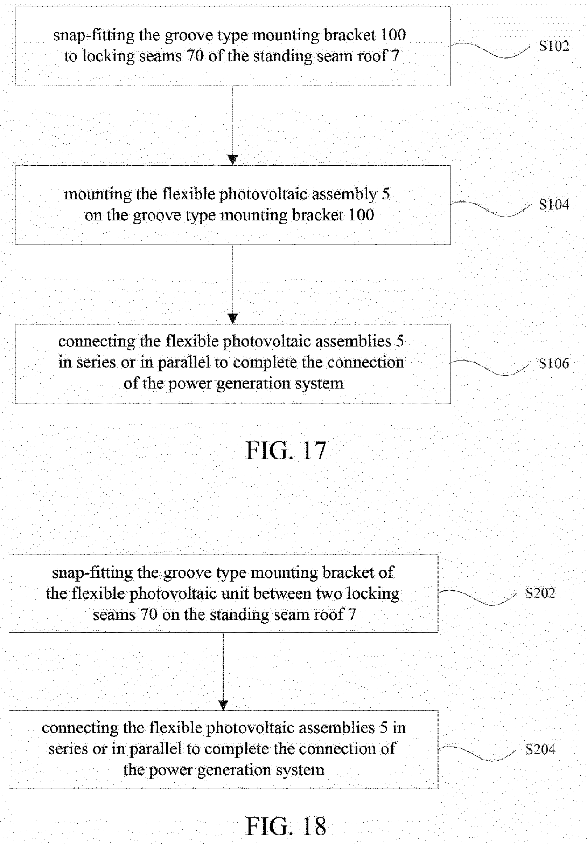

As shown in Fig. 17, the method for mounting the flexible photovoltaic assembly in the first example of this embodiment includes:
S102: snap-fitting the groove type mounting bracket 100 between two locking seams 70 of the standing seam roof 7.

In this step, the groove type mounting bracket 100 can be directly snap-fitted between the two locking seams 70. As shown in Fig. 8, the groove type mounting brackets 100 are arranged at set intervals and each snap-fitted between two locking seams 70 on the standing seam roof 7. Fig. 8 illustrates the groove type mounting bracket shown in Fig. 1, but this application is not limited thereto. The two grooves 3 of the groove type mounting bracket 100 are respectively snapped to the locking seams. A plurality of groove type mounting brackets 100 are arranged at certain intervals in the longitudinal direction of the roof (i.e., the extending direction of the standing seam roof panel) and can be continuously arranged or staggered in the transverse direction to form a grid type platform on the roof.

Taking the groove type mounting bracket 100 shown in Figs. 1 and 2 as an example, and with reference to Fig. 11, by applying an inward pressing force to the two grooves 3 (the openings of the V-shaped sections 31 of the two grooves 3 face toward outside) to bend the two grooves 3 inward, moving the two grooves 3 downward until they are located between the two locking seams 70 so that the V-shaped sections 31 face toward the projections 74 at the ends of the locking seams 70, and then releasing the two grooves 3, after the two grooves 3 return to their original shape, the grooves 3 can be engaged with the locking seams 70. In the case that other groove type mounting brackets described in the above embodiments are used, the process of snapping the groove type mounting brackets to the vertical members extending on the building surface is similar to this process and thus the detailed description thereof is omitted.

S104: mounting the flexible photovoltaic assembly 5 on the groove type mounting bracket 100.

In the example shown in Fig. 9, the size of the flexible photovoltaic assembly 5 is larger than that of the support plate 1 of a single groove type mounting bracket, so that the flexible photovoltaic assembly 5 is mounted and adhered on the support plates 1 in an intermittent manner, that is, one flexible photovoltaic assembly 5 is adhered to the support plates 1 of a plurality of groove type mounting brackets 100 arranged at intervals. The flexible photovoltaic assemblies 5 can be arranged continuously to form a monolithic photovoltaic array on the grid type platform, or the flexible photovoltaic assemblies 5 can be spaced apart from each other to form a spaced photovoltaic array. This mounting method uses as few groove type mounting brackets 100 as possible while ensuring the reliability of the mounting, thus this method can save costs, improve the mounting efficiency, and reduce the building load.

In another example of this embodiment, the size of the flexible photovoltaic assembly 5 is the same as or slightly smaller than the size of the support plate 1 of the groove type mounting bracket 100. In this case each flexible photovoltaic assembly 5 can be adhered onto one groove type mounting bracket 100 to form a spaced photovoltaic array. In yet another example, the size of the flexible photovoltaic assembly 5 is the same as or slightly smaller than the size of the support plate 1 of the groove type mounting bracket 100, and the groove type mounting brackets 100 are continuously arranged on the roof (continuously arranged in both the transverse and longitudinal directions) to form a monolithic platform. In this case, each flexible photovoltaic assembly is adhered onto a groove type mounting bracket 100 to form a monolithic photovoltaic array.

S106: connecting the flexible photovoltaic assemblies 5 in series or in parallel to complete the connection of the power generation system.

In this step, the flexible photovoltaic assemblies can be connected in series or in parallel. As for the whole power generation system, some flexible photovoltaic assemblies can be connected in series and some flexible photovoltaic assemblies can be connected in parallel.

Before or after the groove type mounting bracket 100 is snapped between the two locking seams 70 of the standing seam roof 7, for example, after step 104, adhesive can be applied at the contact position of the groove 3 and the locking seam 70 for fixing. By coating adhesive, e.g., silicone structural adhesive, the groove 3 of the groove type mounting bracket 100 can be adhered and connected to the locking seam 70, making the connection between the groove type mounting bracket 100 and the locking seam 70 more secure, which is beneficial to enhance the robustness of the mounting of the flexible photovoltaic assembly 5.

As shown in Fig. 18, the method for mounting the flexible photovoltaic assembly in the second example of this embodiment includes the following steps:
S202: snap-fitting the groove type mounting bracket 100 of the flexible photovoltaic unit between two locking seams 70 on the standing seam roof 7.

The flexible photovoltaic unit of this embodiment may be, but is not limited to, any of the flexible photovoltaic units described in embodiment 5 and embodiment 6. As previously mentioned, the flexible photovoltaic unit can be directly snapped between the two locking seams 70.

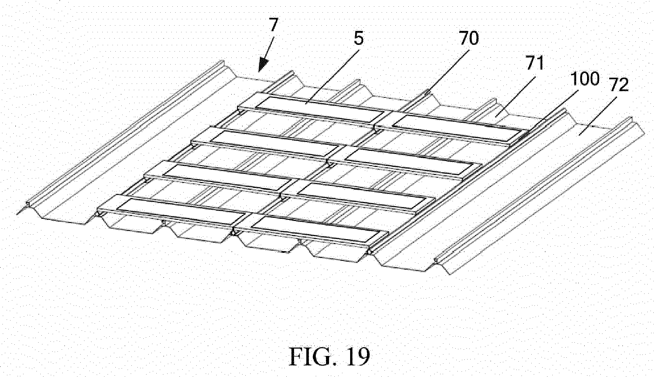

In this step, the structure obtained after the flexible photovoltaic unit is snapped between the two locking seams 70 is shown in Fig. 19. In the illustrated example, the groove type mounting brackets 100 are arranged at certain intervals in the longitudinal direction of the roof and continuously arranged in the transverse direction. However, in another example, the groove type mounting brackets 100 may be continuously arranged in both the longitudinal and transverse directions of the roof to make full use of sunlight.

S204: connecting the flexible photovoltaic assemblies 5 in series or in parallel to complete the connection of the power generation system.

In this step, the flexible photovoltaic assemblies can be connected in series or in parallel. As for the whole power generation system, some flexible photovoltaic assemblies can be connected in series and some flexible photovoltaic assemblies can be connected in parallel.

Before or after the flexible photovoltaic unit is directly snapped between the two locking seams 70 on the standing seam roof 7, for example, after step 204, adhesive, e.g., silicone structural adhesive can be coated at the contact position of the groove 3 and the locking seam 70 for fixing.

Before step 202, the method of this embodiment may further include the following step: fixing (e.g., adhering) the flexible photovoltaic assembly on the groove type mounting bracket to form the flexible photovoltaic unit.

To sum up, in the above method embodiments, by the structural design of the groove type mounting bracket, a method suitable for mounting the flexible photovoltaic assembly is obtained. Due to the simple structure of the groove type mounting bracket, the total weight can be reduced to 20% to 25% of the weight of the traditional mounting assembly, thus reducing the requirement on the load capacity of the building. By adopting of the groove type mounting bracket of the application, the requirement for a flat building surface used for mounting the flexible photovoltaic assembly is no longer required, a quick mounting and dismounting of the flexible photovoltaic assembly is realized, and the application flexibility of the flexible photovoltaic assembly is improved.

In the description of the embodiments of this application, the terms "connect", "fixedly connect", "mount", "install" should be broadly interpreted unless otherwise clearly specified or defined. For example, such terms may be interpreted as fixed connecting, detachable connecting, or connecting into one piece. The terms "mount", "connect" and "fixedly connect" can be interpreted as connecting directly or indirectly through an intermediate component, and can be interpreted as the internal communication between the two elements. For those ordinary skilled in the art, the specific meaning of the above terms in this application can be interpreted according to the specific context.

The above embodiments are merely for specifying this application and do not intend to limit the protection scope of this application. The protection scope of this application is defined by the claims.

## Claims

1. A groove type mounting bracket (100, 100', 100") for a flexible photovoltaic assembly (5), which is configured for mounting the flexible photovoltaic assembly (5) on a standing seam roof (7), and comprises a support plate (1, 1', 1") and grooves (3, 3', 3") arranged on two opposite sides of the support plate (1, 1', 1").

2. The groove type mounting bracket (100, 100', 100") according to claim 1, wherein:
the support plate (1, 1', 1") has a rectangular shape, and the grooves (3, 3', 3") are arranged on two short sides of the support plate (1, 1', 1") or on two long sides of the support plate (1, 1', 1").

3. The groove type mounting bracket (100, 100', 100") according to claim 1 or 2, wherein:
the spacing between two sides of the support plate (1, 1', 1") provided with the grooves (3, 3', 3") is an integer multiple of the width between crests (71) of the standing seam roof (7).

4. The groove type mounting bracket (100, 100', 100") according to claim 1 or 2, wherein the groove type mounting bracket (100, 100', 100") further comprises a vertical support rib (2, 2', 2") arranged along the side of the support plate (1, 1', 1") on which no groove (3, 3', 3") is provided.

5. The groove type mounting bracket (100, 100', 100") according to claim 4, wherein the support plate (1, 1', 1") is provided with a square hole for receiving a junction box (51) of the flexible photovoltaic assembly (5), and a hole through which a wire passes is provided on the side of the support rib (2, 2', 2") close to the short side of the support plate (1, 1', 1").

6. A groove type mounting bracket (100, 100', 100") for a photovoltaic power generation assembly (5), which is configured for mounting the photovoltaic power generation assembly (5) on a building, and comprises a support plate (1, 1', 1") and grooves (3, 3', 3"), wherein the support plate (1, 1', 1") is configured for mounting the photovoltaic power generation assembly (5), and the grooves (3, 3', 3") are arranged at the sides of the support plate (1, 1', 1") and suitable for snap-fitting with vertical members (80, 80') which extend on a building surface and have projections (81, 81') on the sides thereof.

7. The groove type mounting bracket (100, 100', 100") according to claim 6, wherein the groove type mounting bracket (100, 100', 100") at least comprises two grooves (3, 3', 3") arranged on two opposite sides of the support plate (1, 1', 1") and configured to be snap-fitted with two vertical members (80, 80'), the vertical members (80, 80') are locking seams (70) on a standing seam roof (7).

8. The groove type mounting bracket (100, 100', 100") according to claim 7, wherein the two grooves (3, 3', 3") each comprises a groove-shaped section, the shape of the groove-shaped section is set to match the shape of the projection (81, 81'), and the openings of the groove-shaped sections of the two grooves (3, 3') both face toward the outside of the groove type mounting bracket (100, 100'); or the opening of the groove-shaped section of one of the two grooves (3") faces toward the outside of the groove type mounting bracket (100"), and the opening of the groove-shaped section of the other groove faces toward the inside of the groove type mounting bracket (100").

9. The groove type mounting bracket (100, 100', 100") according to claim 6, wherein the support plate (1, 1', 1") is provided with any one or more of weight reducing holes (10), a mounting opening (11) and a wire passing hole (12), wherein the weight reducing holes (10) are a plurality of through holes formed on the support plate (1, 1', 1"), the mounting opening (11) is arranged to receive a junction box (51) of the photovoltaic power generation assembly (5), and the wire passing hole (12) is configured to be passed through by the wire connected to the photovoltaic power generation assembly (5).

10. A photovoltaic power generation unit comprising a photovoltaic power generation assembly (5) and the groove type mounting bracket (100, 100', 100") according to any one of claims 1-9, wherein the photovoltaic power generation assembly (5) is mounted on the support plate (1, 1', 1") of the groove type mounting bracket (100, 100', 100").

11. The photovoltaic power generation unit according to claim 10, wherein the back side of the photovoltaic power generation assembly (5) is provided with a junction box (51), and the support plate (1, 1', 1") is provided with a mounting opening (11) for receiving the junction box (51), and wherein two support ribs (2, 2', 2") are arranged on two opposite sides of the support plate (1, 1', 1") which are not provided with grooves (3, 3', 3"), and the sides of the two support ribs (2, 2', 2") close to the junction box (51) are provided with wire passing holes (21) through which a positive wire and a negative wire (510, 511) led out from the junction box (51) respectively pass.

12. The photovoltaic power generation unit according to claim 10, wherein the front side of the photovoltaic power generation assembly (5) is provided with a junction box (51), wherein two support ribs (2, 2', 2") are arranged on two opposite sides of the support plate (1, 1', 1") which are not provided with grooves (3, 3', 3"), and the sides of the support plate (1, 1', 1") and the two support ribs (2, 2', 2") close to the junction box (51) are provided with wire passing holes (12, 21), and wherein a positive wire and a negative wire (510, 511) led out from the junction box (51) successively pass through the wire passing holes (12, 21) of the support plate (1, 1', 1") and the two support ribs (2, 2', 2").

13. A method for mounting a photovoltaic power generation assembly (5) on a standing seam roof (7), comprising:
mounting the photovoltaic power generation assembly (5) between two locking seams (70) of the standing seam roof (7) by a groove type mounting bracket (100, 100', 100"); and
connecting the photovoltaic power generation assemblies (5) in series or in parallel to complete that connection of a power generation system.

14. The method of claim 13, wherein:
the photovoltaic power generation assembly (5) is a flexible photovoltaic assembly, and said mounting the photovoltaic power generation assembly (5) between two locking seams (70) of the standing seam roof (7) by the groove type mounting bracket (100, 100', 100") comprises:
snap-fitting the groove type mounting bracket (100, 100', 100") according to any one of claims 1-9 between two locking seams (70) on the standing seam roof (7), and then adhering the flexible photovoltaic assembly (5) onto the support plate (1, 1', 1") of the groove type mounting bracket (100, 100', 100"); or
adhering the flexible photovoltaic assembly (5) onto the support plate (1, 1', 1") of the groove type mounting bracket (100, 100', 100") according to any one of claims 1-9, and then snap-fitting the groove type mounting bracket (100, 100', 100") between two locking seams (70) on the standing seam roof (7).

15. The method of claim 14, wherein:
said snap-fitting the groove type mounting bracket (100, 100', 100") according to any one of claims 1-9 between two locking seams (70) on the standing seam roof (7) and then adhering the flexible photovoltaic assembly (5) onto the support plate (1, 1', 1") of the groove type mounting bracket (100, 100', 100") comprises:
arranging the groove type mounting brackets (100, 100', 100") according to any one of claims 1 to 9 at set intervals, snap-fitting the groove type mounting bracket (100, 100', 100") between two locking seams (70) on the standing seam roof (7), so that a grid type platform is formed on the standing seam roof (7), and then adhering and mounting the flexible photovoltaic assemblies (5) discontinuously on the support plates (1, 1', 1") to form a monolithic photovoltaic array.
